# DEMANDE DE BREVET EUROPEEN

(11) **EP 4 524 283 A1**
(43) Date de publication de la demande: **19.03.2025**
(21) Numéro de dépôt: 24197933.5
(22) Date de dépôt: 02.09.2024
(51) Int. Cl.: C23C 14/06, C23C 14/24, C30B 23/06, C30B 29/12, H10F 99/00

(54) **PROCEDE D´ELABORATION D'UNE COUCHE DE PEROVSKITE HYBRIDE ORGANIQUE-INORGANIQUE DE COMPOSITION CONTROLEE**

(30) Priorité: 12.09.2023 FR 2309596
(71) Demandeur: Commissariat à l'Energie Atomique et aux Energies Alternatives, 75015 Paris (FR)
(72) Inventeur: GRENET, Louis, 38054 Grenoble Cedex 09 (FR); TESTARD, Elodie, 38054 Grenoble Cedex 09 (FR); ROUX, Frédéric, 38054 Grenoble Cedex 09 (FR)
(74) Mandataire: Cabinet Beaumont

(57) **Abrégé**

La présente description concerne un procédé d'élaboration d'une couche de pérovskite organique-inorganique comprenant les étapes suivantes :
- Formation d'une couche de précurseurs inorganiques sur un substrat,
- Mise en œuvre d'une étape de sublimation à faible distance à partir d'une poudre comprenant les précurseurs organiques, moyennant quoi les vapeurs de la couche de précurseurs organiques réagissent avec la couche de précurseurs inorganiques et une couche de pérovskite hybride organique-inorganique est formée,
la poudre de précurseurs organiques étant obtenue par mécanosynthèse en cobroyant au moins un premier groupe de particules en un premier matériau et un deuxième groupe de particules en un deuxième matériau, jusqu'à former un troisième groupe de particules en un troisième matériau, le troisième groupe de particules formant la poudre de précurseurs organiques.

## Description

### Domaine technique

La présente description concerne de façon générale le domaine des pérovskites hybrides organiques-inorganiques, et plus particulièrement leur procédé d'élaboration.

L'invention trouve des applications dans de nombreux domaines industriels, en particulier dans le domaine photovoltaïque, ou encore pour la fabrication de dispositifs électroniques, optiques ou optoélectroniques, en particulier pour la fabrication de diodes électroluminescentes (DEL), de photo-détecteurs, de scintillateurs, de détecteurs de rayons X par exemple pour le médical ou encore de transistors.

L'invention est particulièrement intéressante puisqu'elle permet de former des couches de pérovskites de composition contrôlée avec des temps de dépôt relativement courts.

### Technique antérieure

Les pérovskites hybrides organiques-inorganiques sont des matériaux particulièrement intéressants pour les cellules photovoltaïques, et notamment pour les cellules photovoltaïques tandem sur silicium.

Parmi les matériaux hybrides organiques-inorganiques particulièrement prometteurs, on peut citer les matériaux de type ABX₃ avec A représentant un cation ou un mélange de cations choisis parmi Cs⁺, FA⁺ (avec FA= CH₅N₂), MA⁺ (avec MA = CH₃-NH₃), B un cation métallique choisi parmi Pb, Sn, Ge et X un halogène choisi parmi Cl, Br et I.

Généralement, les procédés d'élaboration de couches de pérovskites hybrides sont réalisés en deux étapes : la partie inorganique de la pérovskite est déposée en premier puis est amenée à réagir avec la partie organique pour former la pérovskite.

Par exemple, dans l'article de Sahli et al. (Nature Materials 2018, 17, 820826), une couche de matériau pérovskite de formule CsₓFA₁₋ₓPb(I,Br)₃ est obtenue en formant, dans un premier temps, une couche poreuse par co-évaporation d'iodure de plomb (PbI₂) et de bromure de césium (CsBr). Puis une solution d'organohalogénures comprenant de l'iodure de formamidinium (FAI) et du bromure de formamidinium (FABr) est déposée par dépôt à la tournette (« spin-coating »). Après un recuit à 150 °C à l'air ambiant, la pérovskite est cristallisée.

Dans l'article de Zhang et al. (ACS Appl. Energy Mater. 2022, 5, 5797-5803), des films de Cs_{0.14}FA_{0.86}Pb(BrₓI₁₋ₓ)₃ sont également obtenus en mettant en oeuvre un procédé en deux étapes. Dans un premier temps, des couches inorganiques de CSI et PbI₂ sont déposées de manière séquentielle sur un substrat. Dans un deuxième temps, un film organique de FAI ou un film organique de FAI/FABr est préparé en déposant par une pulvérisation une solution d'éthanol comprenant les précurseurs. Ce film est utilisé pour mettre en oeuvre une étape de sublimation à faible distance (ou CSS pour « Close Space Sublimation ») à une température de 160°C. Lors de cette étape, le matériau est sublimé, ce qui permet de faire réagir les vapeurs organiques avec les couches de CSI et PbI₂ et ainsi former le matériau pérovskite.

Dans les procédés CSS, il est également connu qu'il est possible d'utiliser une poudre de précurseurs, par exemple sous la forme d'une galette solide (cible). Un tel procédé est facile à mettre en oeuvre dans le cas où il y a un seul précurseur. Cependant, dans le cas où il y a deux précurseurs différents, par exemple des particules de FAI et des particules FABr, le procédé est plus difficile à mettre en oeuvre.

En effet, la température maximale admissible dans un procédé de CSS doit être inférieure à la température de fusion de la cible. Or, la température de fusion du FAI est de 242°C et celle du FABr est de 135°C. Ainsi, au-delà de 125°C, on observe une fusion partielle de la cible et/ou l'accroche sur le suscepteur.

De plus, si la température de travail est trop faible, les cinétiques de réactions sont moins rapides et la durée du procédé peut être considérablement allongée.

Par ailleurs, la sublimation du FABr se faisant à plus basse température que celle du FAI, le rapport FABr/FAI dans l'atmosphère est plus élevé que celui de la cible, ce qui entraîne deux problèmes majeurs. En premier lieu, le contrôle de la quantité des rapports FABr/FAI dans la cible pour obtenir le taux souhaité de Br dans la pérovskite est difficile à déterminer puisque le rapport FABr/FAI dans l'atmosphère est différent de celui de la cible.

Ensuite, la composition de la cible évolue au cours du temps puisque le FABr se sublime préférentiellement au FAI, ce qui modifie le rapport FABr/FAI dans la cible au cours du temps. Le matériau déposé n'a donc pas ni une composition homogène ni la composition voulue.

### Résumé de l'invention

Il existe donc un besoin d'obtenir un procédé permettant de former une couche de pérovskite hybride organique-inorganique dont la composition est contrôlée.

Ce but est atteint par un procédé d'élaboration d'une couche de pérovskite organique-inorganique comprenant les étapes suivantes :
- Formation d'une couche de précurseurs inorganiques sur un substrat,
- Mise en oeuvre d'une étape de sublimation à faible distance à partir d'une poudre de précurseurs organiques, moyennant quoi les vapeurs de la poudre de précurseurs organiques réagissent avec la couche de précurseurs inorganiques et une couche de pérovskite hybride organique-inorganique est formée, la poudre de précurseurs organiques étant obtenue par mécanosynthèse, en cobroyant au moins un premier groupe de particules en un premier matériau et un deuxième groupe de particules en un deuxième matériau, jusqu'à former un troisième groupe de particules en un troisième matériau, le troisième groupe de particules formant la poudre de précurseurs organiques.

L'invention se distingue fondamentalement de l'art antérieur en ce que la deuxième étape du procédé est réalisée avec une poudre de précurseurs inorganiques obtenue par mécanosynthèse.

La poudre obtenue par mécanosynthèse comprend des particules dont la composition correspond à la composition que l'on souhaite faire réagir avec la couche de précurseurs inorganiques préalablement déposée. Les particules sont, de préférence, monophasées.

Ainsi, lorsque le troisième matériau est sublimé lors de l'étape b), les vapeurs du troisième matériau réagissent avec la couche de précurseurs inorganiques pour former la pérovskite.

L'utilisation de particules obtenues par mécanosynthèse est particulièrement intéressante d'un point de vue industriel car comme les particules formant la poudre ont toutes la même composition, cela permet d'augmenter la température de l'étape CCS et donc de réduire la durée de cette étape.

Par exemple, la température de fusion du FA(I_{1-y}Br_{y}) est comprise entre celle du FAI et FABr.

De plus, les vapeurs générées lors de l'étape CCS ont tout le temps la même composition car la composition de la cible reste constante au cours du procédé. Le matériau pérovskite ainsi formé est homogène et a la composition voulue.

Avantageusement, la pérovskite hybride organique-inorganique a pour formule A'₁₋ₓAₓBX₃ avec _{:} A' un cation inorganique ou un alliage de cations inorganiques, de préférence choisis parmi Cs, Rb, K et Na, A un cation organique monovalent ou un alliage de cations organiques monovalents, de préférence choisis parmi le méthylammonium (MA), le formamidinium (FA), le guanidinium (GA), le diméthylammonium (DA) et l'imidazolium (IA), encore plus préférentiellement A correspond à MA et/ou FA, B un cation inorganique ou un alliage de cations inorganiques, de préférence choisis parmi Pb, Sn et Ge, X un ou plusieurs halogènes, de préférence choisis parmi Cl, Br, I et F.

Avantageusement, la pérovskite hybride organique-inorganique a pour formule Cs₁₋ₓMAₓPb(I_{1-y}Br_{y})₃, Cs₁₋ₓFAₓPb(I_{1-y-z}Br_{y}Cl_{z})₃ ou Cs₁₋ₓFAₓPb(I_{1-y}Br_{y})₃, Cs₁₋ₓFAₓPb_{0.5}Sn_{0.5}(I_{1-y}Br_{y})₃, Cs_{1-x-z}MAₓFA_{z}Pb(I_{1-y}Br_{y})₃ ou Cs_{1-x-z}MAₓFA_{z}Pb₁₋ₖSnₖ(I_{1-y}Br_{y})₃ avec 0 ≤ y ≤ 1, 0 ≤ k ≤ 1, 0 ≤ x ≤ 1, 0 ≤ z ≤ 1 et 0 ≤ x+z ≤ 1, et de préférence 0 < y < 1 et 0 < x < 1.

Avantageusement, la poudre de précurseurs organiques comprend des particules de formule AX avec A représentant un cation organique monovalent ou un alliage de cations organiques monovalents, de préférence MA et/ou FA, X représentant un ou plusieurs halogènes choisis parmi Cl, Br, I et F. De plus, A représente un alliage de cations organiques monovalents et/ou X représente plusieurs halogènes.

Avantageusement, la poudre de précurseurs organiques est une poudre de FA(I_{1-y}Br_{y}) ou une poudre de MA(I_{1-y}Br_{y}) avec 0 < y < 1. De telles poudres peuvent être formées par mécanosynthèse, respectivement, à partir d'une poudre de FAI et d'une poudre de FABr ou à partir d'une poudre de MAI et d'une poudre de MABr.

Avantageusement, la couche comprenant les précurseurs inorganiques est une couche contenant du Pb, du Cs et un ou plusieurs halogènes choisis parmi l'iode, le brome et le chlore.

Par exemple, la couche de précurseurs inorganiques est une couche de PbI₂ et de CsI, une couche de PbI₂ et de CsBr, une couche de PbBr2 et de CsI, une couche de PbBr₂ et de CsBr, une couche de PbI₂, PBBr₂ et CsI, une couche de PbI₂, PBBr₂ et CsBr, une couche de PbI₂, CsI et CsBr, une couche de PbBr₂, CsI et CsBr ou une couche de PbBr₂, PbI₂, CSI et CsBr. De préférence, il s'agit de PbI₂ et CsBr ou de PbI₂ et CsI.

Avantageusement, la poudre de précurseurs organiques peut être sous la forme d'une cible solidaire ou d'un lit de poudres.

Selon une variante avantageuse de réalisation, la couche de précurseurs inorganiques est formée par évaporation thermique ou dépôt à la tournette.

Selon une autre variante avantageuse de réalisation, la couche de précurseurs inorganiques est formée par CSS.

Avantageusement, le substrat est un substrat adapté au domaine photovoltaïque. Par exemple, il peut s'agir d'un substrat en verre, en plastique ou en métal.

Avantageusement, le substrat est un substrat de silicium, de préférence un substrat de silicium texturé. Un tel substrat est particulièrement intéressant pour former un dispositif photovoltaïque.

L'invention concerne également un procédé de fabrication d'une cellule photovoltaïque multi-jonction comprenant au moins une cellule photovoltaïque en pérovskite ou d'une cellule photovoltaïque pérovskite à simple jonction, le procédé comprenant l'élaboration d'une couche de pérovskite organique-inorganique selon le procédé tel que décrit précédemment.

La cellule photovoltaïque multi-jonction comprenant au moins une cellule photovoltaïque en pérovskite est, par exemple, une cellule photovoltaïque tandem pérovskite-silicium, une cellule photovoltaïque tandem pérovskite-pérovskite, une cellule photovoltaïque triple jonction pérovskite-pérovskite-silicium ou une cellule photovoltaïque triple jonction pérovskite-pérovskite-pérovskite.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 représente de manière schématique et en coupe une partie d'un four de sublimation à faible distance dispositif selon un mode de réalisation particulier de l'invention ;
la figure 2 représente de manière schématique et en coupe un four de sublimation à faible distance selon un autre mode de réalisation particulier de l'invention ;
les figures 3A et 3B sont des représentations schématiques et en coupe, respectivement, d'une cellule photovoltaïque simple jonction et d'une cellule photovoltaïque tandem, selon différents modes de réalisation particuliers de l'invention ;
la figure 4 est un graphique représentant des diffractogrammes des Rayons X d'une poudre de FA(I_{1-y}Br_{y}) avec y~0,5 obtenue par mécanosynthèse selon un mode de réalisation particulier de l'invention, ainsi que d'une poudre de FAI, d'une poudre de FABr et d'une poudre obtenue par simple mélange de FAI et FABr, ces dernières étant données à titre comparatif. Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % près, de préférence à 5 % près.

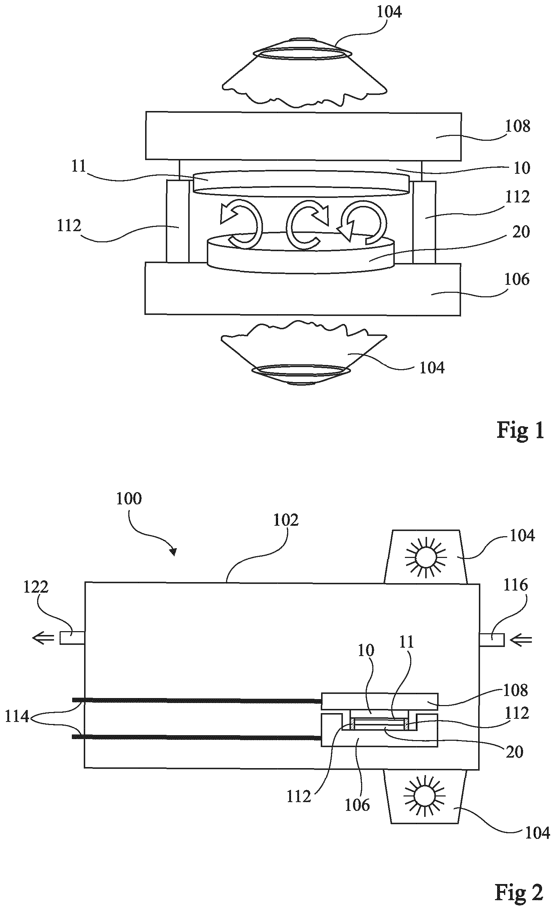

Le procédé que nous allons par la suite décrire plus en détail, en faisant référence aux figures 1 et 2, concerne l'élaboration d'une couche de pérovskite hybride organique-inorganique.

La pérovskite hybride organique-inorganique a, de préférence, pour formule générale A'₁₋ₓAₓBX₃ avec _{:} A' un cation inorganique ou un alliage de cations inorganiques, de préférence choisis parmi Cs, Rb, K et Na, A un cation organique monovalent ou un alliage de cations organiques monovalents, choisis parmi CH₃NH₃⁺ (méthylammonium ou MA), CH(NH₂)₂⁺ (formamidinium ou FA), C(NH₂)₃⁺ (guanidinium ou GA), C₂H₈N (diméthylammonium ou DA), C₃H₅N₂ (imidazolium ou IA) ; un alliage de cations organiques monovalents peut être, par exemple, MA₁₋ₓFAₓ avec 0<x<1), B un cation inorganique ou un alliage de cations inorganiques, de préférence choisis parmi Pb, Sn et Ge, X un ou plusieurs halogènes, de préférence choisis parmi Cl, Br, I et F.

De préférence, A' représente Cs.

De préférence, A représente MA et/ou FA.

De préférence, B représente Pb, Sn et Ge,

De préférence, X représente Br et/ou I.

Avantageusement, la pérovskite hybride organique-inorganique a pour formule Cs₁₋ₓMAₓPb(I_{1-y}Br_{y})₃, Cs₁₋ₓFAₓPb(I_{1-y-z}Br_{y}Cl_{z})₃ ou Cs₁₋ₓFAₓPb(I_{1-y}Br_{y})₃ ou Cs₁₋ₓFAₓPb_{0.5}Sn_{0.5}(I_{1-y}Br_{y})₃ ou Cs_{1-x-z}MAₓFA_{z}Pb(I_{1-y}Br_{y})₃ ou Cs_{1-x-z}MAₓFA_{z}Pb₁₋ₖSnₖ(I_{1-y}Br_{y})₃ avec 0 ≤ y ≤ 1 , 0 ≤ k ≤ 1, 0 ≤ x ≤ 1, 0 ≤ z ≤ 1 et 0 ≤ x+z ≤ 1, et de préférence 0 < y < 1 et 0 < x < 1.

Le procédé comprend les étapes suivantes :
a) Formation d'une couche de précurseurs inorganiques 11 sur un substrat 10,
b) Mise en oeuvre d'une étape de sublimation à faible distance à partir d'une poudre 20 comprenant les précurseurs organiques, la poudre 20 étant obtenue par mécanosynthèse, la distance entre la poudre 20 de précurseurs organiques et le substrat 10 étant, par exemple, comprise entre 0,1 et 5 mm, moyennant quoi les précurseurs organiques réagissent avec la couche de précurseurs inorganiques 11 et une couche de pérovskite hybride organique-inorganique est formée (figures 1 et 2).

La poudre 20 utilisée à l'étape b) est préparée lors d'une étape, préalablement à l'étape b), par exemple entre l'étape a) et l'étape b), ou de préférence avant l'étape a).

La préparation de la poudre 20 est réalisée selon les sous-étapes suivantes :
- fournir au moins un premier groupe de particules en un premier matériau et un deuxième groupe de particules en un deuxième matériau,
- réaliser une sous-étape de mécanosynthèse par cobroyage au moins du premier groupe de particules et du deuxième groupe de particules, jusqu'à former un troisième groupe des particules en un troisième matériau.

La poudre finale 20 comprend majoritairement, et de préférence, est constituée du troisième groupe de particules. La composition de ces particules correspond à la composition à faire réagir avec la couche de précurseurs déposée lors de l'étape a).

La sous-étape de mécanosynthèse se fait donc par co-broyage de plusieurs poudres.

Le cobroyage est réalisé avec au moins deux groupes de particules. Il pourrait également être mis en oeuvre avec plus de deux groupes de particules (par exemple trois ou quatre groupes de particules).

La sous-étape de mécanosynthèse consiste à réaliser un co-broyage très énergique des matériaux purs ou pré-alliés dans un broyeur à haute énergie jusqu'à l'obtention d'une poudre 20 dont les particules sont monophasées ou polyphasées. De préférence les particules sont monophasées.

Le co-broyage est réalisé dans un broyeur planétaire à billes. La masse de billes est au moins deux fois supérieure à la masse de poudres, par exemple au moins 15 fois supérieure.

La vitesse de rotation du broyage est élevée (typiquement de 100 tours/min à 700 tours/min, par exemple 500 tours/min) . Elle dépend du broyeur utilisé ainsi que de la masse de billes et de poudres. Le temps de broyage est par exemple entre 10min et 5h, par exemple 1h.

Le mélange peut être un mélange équimolaire.

La poudre de précurseurs organiques obtenue par mécanosynthèse comprend, et de préférence est constituée, de particules de formule générale AX avec A un cation organique monovalent ou un alliage de cations organiques monovalents, de préférence MA et/ou FA, X représentant un ou plusieurs halogènes choisis parmi Cl, Br, I et F. Dans cette formule générale, A représente un alliage de cations organiques monovalents et/ou X représente plusieurs halogènes.

De préférence, A est un alliage de cations organiques monovalents et X un alliage d'halogènes.

A partir de cette poudre, il est possible par CSS de synthétiser une couche pérovskite de formule générale A'₁₋ₓAₓBX₃ avec A' est un alliage de cations inorganiques (Cs, Rb, K, Na), 0<x<1 et B un cation (Pb) ou alliage de cations inorganiques (Pb, Sn, Ge).

Selon un mode particulier de réalisation, la poudre 20 de précurseurs organiques comprend des particules de MA(I_{1-y}Br_{y}) avec 0<y<1. La poudre est obtenue par mécanosynthèse à partir de MAI et de MABr. Elle peut, par exemple, servir pour former des couches de Cs₁₋ₓMAₓPb(I_{1-y}Br_{y})₃.

Selon un autre mode particulier de réalisation, il est possible par exemple d'obtenir une poudre 20 en MA₂FA₁₋₂I_{1-y}Br_{y} (avec 0<z<1 et 0<y<1) à partir de poudres de MABr et/ou MAI et/ou FABr et/ou FAI. La mécanosynthèse de ces poudres permet de former, par exemple, des couches de CsₓMA_{z}FA_{1-z-x}Pb(I_{1-y}Br_{y})₃.

Selon un autre mode particulier de réalisation, il est possible d'utiliser des poudres de FAI et/ou FABr et/ou FACl pour former des poudres 20 en FAI_{1-y-z}Br_{y}Cl_{z} (avec 0<y<1 et 0<z<1) par exemple pour former des couches de Cs₁₋ₓFAₓPb(I_{1-y-z}Br_{y}Cl_{z})₃.

La poudre 20 obtenue peut être utilisée telle quelle, notamment sous la forme d'un lit de poudres.

Selon une variante de réalisation avantageuse, la poudre 20 obtenue est utilisée pour fabriquer une cible solide (aussi appelée galette). Pour cela, la poudre 20 est pressée, par exemple avec une presse hydraulique avec P ~ 1x10⁷ Pa). Le pressage de la cible peut se faire en chauffant la poudre.

Lors de l'étape a), les précurseurs inorganiques de la pérovskite sont déposés sur le substrat 10 pour former une couche 11 de précurseurs inorganiques. De préférence, les précurseurs contiennent du plomb et du césium. Des halogénures de plomb et des halogénures de césium sont avantageusement utilisés.

De préférence, les précurseurs inorganiques sont choisis parmi des matériaux suivants : CsCl, CsBr, CsI, PbCl₂, PbBr₂ et PbI₂, avec, préférentiellement au moins un halogénure de Cs et un halogénure de Pb. Il peut s'agir d'une combinaison de deux, de trois ou plus de trois précurseurs.

Par exemple, les précurseurs inorganiques sont choisis parmi l'une des combinaisons suivantes : une combinaison de deux matériaux comme PbI₂ et CsI, PbI₂ et CsBr, PbBr₂ et CsI, PbBr₂ et CsBr, ou encore une combinaison de trois matériaux PbI₂, PBBr₂ et CsI ou PbI₂, PBBr₂ et CsBr ou PbI₂, CSI et CsBr ou PbBr₂, CSI et CsBr ou encore une combinaison de quatre matériaux PbBr₂, PbI₂, CSI et CsBr. De préférence, il s'agit de PbI₂ et CsBr ou de PbI₂ et CsI.

La couche de précurseurs inorganiques 11 est, par exemple, déposée par évaporation thermique ou dépôt à la tournette (« spin coating ») .

Selon un mode de réalisation particulier, la couche de précurseurs inorganiques 11 peut être aussi déposée par CSS.

La couche de précurseurs inorganiques 11 a une épaisseur de quelques centaines de nanomètres, par exemple 300 nm.

Le substrat utilisé peut être un substrat en verre, en polymère (polyimide par exemple), en acier. De préférence, il est en silicium. Le substrat en silicium peut être texturé ou non texturé. Il peut être poli.

Avantageusement, le substrat est fonctionnalisé avec une couche ou un empilement de couches isolantes, conductrices ou semi-conductrices pour injecter et/ou collecter des charges dans le matériau pérovskite.

La seconde étape consiste à faire réagir la couche de précurseurs inorganiques 11 avec les précurseurs organiques pour former la pérovskite. Cette étape est réalisée par CSS.

Le substrat 10 recouvert par la couche 11 de précurseurs inorganiques est positionné face à la poudre 20 de précurseurs organiques (lit de poudres ou cible formée de particules agglomérées).

L'ensemble est chauffé sous vide (par exemple 50-100 Pa). La distance entre la poudre 20 de précurseurs organiques et le substrat 10 est, par exemple, comprise entre 0,1 et 5 mm.

Les précurseurs organiques changent d'état et passent sous forme gazeuse (représentée par des flèches sur la figure 1) et ils réagissent avec la couche 11 précurseurs inorganiques pour former le matériau pérovskite hybride organique-inorganique.

L'étape b) est réalisée dans un four de sublimation à faible distance.

Un four à lampe peut être utilisé pour réaliser cette étape.

Par exemple, comme représenté sur la figure 2, le four CSS 100 comprend un réacteur 102 autour duquel est positionné un système de chauffage. Par exemple, il peut s'agir de lampes 104 (figure 2) ou de toute autre système de chauffage (résistance par exemple) .

Le réacteur 102 peut être en quartz, en graphite, en métal.

Le réacteur 102 peut être tubulaire.

Comme représenté sur les figures 1 et 2, le four 100 comprend également un suscepteur 106 (aussi appelé bloc source) et un couvercle 108 (aussi appelé bloc substrat). Le suscepteur 106 et le couvercle 108 sont en des matériaux thermiquement conducteurs, pouvant résister à la pression, au vide et à de fortes températures. Ils sont, de préférence, en graphite.

Le substrat 10 et la cible 20 sont positionnés entre le suscepteur 106 et le couvercle 108.

De préférence, le substrat 10 est en contact direct avec le couvercle 108 qui maintient sa température à la valeur de consigne.

La poudre 20 de précurseurs organiques est disposée sur le suscepteur 106.

Le substrat 10 est à faible distance de la poudre 20. Par faible distance, on entend une distance typiquement de 0,1 mm à 20 mm, préférentiellement de 1 mm à 7mm, par exemple de 0,1 mm à 5 mm ou de 3 mm à 5 mm. Notamment, on pourra choisir une distance de 1 mm.

Un ou plusieurs espaceurs 112, pouvant être en un matériau isolant thermique (par exemple verre, quartz, ou alumine) servent à maintenir le substrat 10 à faible distance de la poudre 20.

Le couvercle 108 peut être maintenu plaqué sur le substrat par un système de fermeture dans le suscepteur 106 non représenté (par exemple une vis ou tout autre système de fixation).

Le suscepteur 106 et le couvercle 108 possèdent chacun un thermocouple 114 ou tout autre système (pyromètre, ...) pour mesurer et piloter leur température.

Un système de chauffage (lampe, résistances, ...) permet de réguler la température du suscepteur 106 (Tcible) et du couvercle 108 (Tsubstrat) dans une gamme pouvant aller de 20°C à 600°C. Des rampes de montée en température sont pilotables dans une gamme, par exemple, de 0,1°C/s à 10°C/s. Le suscepteur 106 (Tcible) et le couvercle 108 (Tsubstrat) peuvent être piloté par des rampes (ou séquences de rampes) de température, de manière indépendante. Ainsi, il est possible d'ajuster les cinétiques de sublimation de la poudre 20 et les températures de réaction avec la couche inorganique déposée sur le substrat 10 de façon à contrôler la morphologie de la couche et/ou la durée du procédé.

Le dispositif 100 est relié à un système à une arrivée de gaz inerte 116 (tel que de l'argon ou N₂).

Le dispositif 100 peut également être relié à une arrivée de gaz oxydant (tel que O₂) ou à une arrive de gaz réducteur (tel que H₂).

Le dispositif 100 comprend une sortie de gaz 122, reliée à un système de pompage permettant d'atteindre un vide Pfour allant, par exemple, de 0,00001 Pa - 1 Pa. La valeur Pfour dépend du four CSS utilisé.

Lors de l'étape b), la cible est sublimée. Le dépôt par sublimation se fait en chauffant le suscepteur 106 et le couvercle 108 sous vide.

Lors de l'étape b), la température de la cible peut être identique à la température du substrat.

Selon une variante de réalisation, lors de l'étape b), la température du substrat Tsub est, avantageusement, inférieure à la température de la cible Tcible afin de créer un gradient thermique tout en favorisant une plus grande pression partielle de composé organique sans risquer de décomposer la pérovskite. La différence de température Tcible - Tsub est de 1°C à 350°C (par exemple de 1 à 100°C, notamment 20°C), de préférence de 50°C à 300°C et encore plus préférentiellement de 100°C à 250°C, par exemple de 150°C.

Selon une autre variante de réalisation, lors de l'étape b), Tcible < Tsubstrat pour favoriser la condensation de la vapeur sur le substrat et ainsi accélérer la réaction. La différence de température peut être de 1 à 100°C, par exemple 20°C.

Les températures visées dépendent du matériau à sublimer.

Les couches de pérovskite obtenues peuvent être utilisées dans de nombreux domaines industriels, en particulier, dans le domaine de la détection X pour le médical, la sûreté, la sécurité, la radioprotection, ou les grands instruments scientifiques, mais aussi dans le domaine du photovoltaïque, de la détection de rayonnement gamma, de rayonnements ionisants (alpha, beta, neutron) ou encore pour la fabrication de dispositifs électroniques, optiques ou optoélectroniques, en particulier pour la fabrication de diodes électroluminescentes (DEL), de photo-détecteurs, de scintillateurs ou encore de transistors.

En particulier, le procédé s'applique pour déposer des pérovskites hybrides organiques inorganiques de faibles épaisseurs (comprises entre 10 nm et 5000 nm). Ces matériaux sont généralement utilisés pour les applications optiques visible ou proche infra-rouge. On citera notamment les applications photovoltaïques, mais aussi la détection infra-rouge et proche infrarouge ou l'émission de lumière dans les longueurs d'onde visible, proche infra-rouge et infra rouge.

De manière avantageuse, en ce que qui concerne les applications photovoltaïques, le procédé précédemment décrit peut être utilisé pour élaborer une couche de matériau pérovskite hybride organique-inorganique dans une cellule photovoltaïque.

En jouant sur la quantité d'iode et de brome dans le matériau pérovskite, il est possible de modifier l'énergie de bande interdite.

Les cellules photovoltaïques peuvent être des cellules simples jonctions ou des cellules multi-jonction.

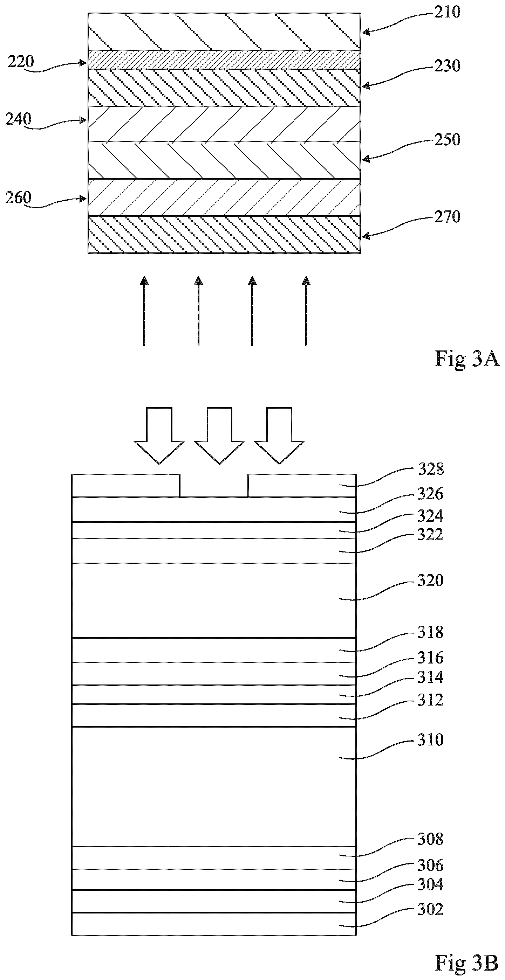

Par exemple, une cellule photovoltaïque simple jonction de type p-i-n, peut comprendre depuis la face arrière vers la face avant (figure 3A) :
- une électrode supérieure 210,
- une couche tampon 220,
- une couche de type n 230,
- une couche active en pérovskite 240,
- une couche de type p 250,
- une couche d'oxyde transparent conducteur 260,
- un substrat 270.

De préférence, la cellule photovoltaïque est constituée des différents éléments cités ci-dessus.

La face avant de la cellule photovoltaïque est destinée à recevoir un flux lumineux.

Le rayonnement incident est représenté par des flèches sur la figure 3A.

L'électrode supérieure 210 est, par exemple, en Ag, Cu, Ni, Al.

La couche tampon 220 peut être une couche en LiF, SnS, en oxyde métallique ou en BCP (bathocuproine).

La couche de type n 230 peut être par exemple en C60, PC61BM ([6,6]-phényl-C61 -butanoate de méthyle ou « [6,6]-phenyl-C61-butyric acid methyl ester »), PC71BM ([6,6]-phényl-C71-butanoate de méthyle ou « [6,6]-phenyl-C71-butyric acid methyl ester »), PCBM/C60 ou PCBM/C. De préférence, elle est en C60.

Selon d'autres variantes de réalisation, la couche de type n 230 peut être une couche d'oxyde, par exemple SnOx (avec x compris entre 1 et 2), ZnO, Al :ZnO, ITO ou IZO.

La couche active 240 est une couche active en pérovskite obtenue par le procédé précédemment décrit. De préférence la couche de pérovskite est une pérovskite de type APbX₃ avec A représentant des cations de méthylammonium, diméthylammonium, formamidinium, guanidinium ou césium (les cations précités peuvent être utilisés seuls ou en mélange) et X représentant des anions halogénures (de préférence des anions chlore, brome, iode seuls ou en mélange).

La couche active 240 a, par exemple, une épaisseur comprise entre 200 nm et 1,5 µm.

Selon une première variante, la couche de type p 250 peut être une couche de poly(3,4-éthylènedioxythiophène) (PEDOT) ou de poly[bis(4-phényl) (2,4,6-triméthylphényl)amine (PTAA).

Selon une deuxième variante, la couche de type p 250 est une couche autoassemblée (ou SAM pour « Self-Assembled Monolayer »). La couche de SAM peut être une couche de 2PACz (acide [2-(9H-Carbazol-9-yl)éthyl]phosphonique), 3PACz (acide 3-(9H-carbazol-9-yl)propyl)phosphonique), 4PACz (acide 4-(9H-carbazol-9-yl)butyl)phosphonique), Me-4PACz (acide (4-(3,6-Diméthyl-9H-carbazol-9-yl)butyl)phosphonique), MeO-2PACz (acide (2-(3,6-Diméthoxy-9H-carbazol-9-yl)éthyl)phosphonique), 6dPA (acide 1,6-hexylènediphosphonique) ou encore une couche de MPA (acide méthylphosphonique) ou une couche obtenue à partir d'un mélange de ces molécules. Il peut également s'agir d'un de leurs dérivés.

Selon une troisième variante, la couche de type p 250 est une couche d'oxyde, par exemple une couche de MoOₓ, une couche de NiOₓ.

Selon une autre variante, la couche de type p 250 peut être un bicouche oxyde/SAM, par exemple un bicouche NiOₓ/SAM.

La couche d'oxyde transparent conducteur 260 peut être une couche d'oxyde d'indium-étain (ou ITO).

Ces différents éléments sont positionnés sur un substrat 270 disposé en face arrière. Le substrat 270 est, par exemple, en verre.

Nous allons maintenant décrire plus en détail une cellule photovoltaïque tandem Si/pérovskite. Une telle cellule comprend une sous-cellule inférieure en silicium (Si) et une sous-cellule supérieure en pérovskite (PK).

Une telle cellule est par exemple représentée sur la figure 3B. Cette structure est dite de type « inverse » ou p-in. La cellule comprend depuis la face arrière vers la face avant :
- une première électrode 302,
- une première couche d'oxyde transparent conducteur 304, par exemple en ITO ou AZO,
- une couche de silicium amorphe dopé p 306,
- éventuellement une couche de silicium amorphe intrinsèque 308,
- une couche active en silicium cristallin 310,
- éventuellement une couche de silicium amorphe intrinsèque 312,
- une couche de silicium amorphe dopé n 314,
- une deuxième couche d'oxyde transparent conducteur 316, par exemple en ITO ou AZO,
- une couche de type p (HTL) 318, par exemple en PEDOT, PTAA, ou encore en oxyde (MoOₓ ou NiOₓ par exemple) ou formée d'une SAM,
- une couche active en pérovskite 320, par exemple de formule APbX₃,
- une couche de passivation, par exemple, MgFx, AlOx, LiF,
- une couche de type n (ETL) 322, par exemple en C₆₀,
- une couche tampon 324, par exemple en BCP ou en oxyde comme SnOₓ,
- une troisième couche d'oxyde transparent conducteur 326, par exemple en ITO ou AZO,
- une deuxième électrode 328, par exemple en Ag, Cu, Ni ou Al.

Les différents matériaux utilisés pour la sous-cellule supérieure en pérovskite (PK) peuvent être par exemple choisis parmi les matériaux précédemment décrits pour la cellule simple jonction.

La méthode de dépôt par CSS est particulièrement adaptée pour former des cellules solaires à base de pérovskite sur une cellule inférieure en Si. La cellule inférieure peut présenter une surface texturée (par exemple, une surface sous la forme de pyramides de 1 à 2 µm de hauteur). Dans le cas de cellules tandem sur Si, il pourra en particulier s'agir de la pérovskite Cs₁₋ₓFAₓPb(I_{1-y}Br_{y})₃ avec 0,65<x<0,9 (de préférence x~0,8) et y~0,3. Le taux de Br peut être facilement ajusté pour obtenir une bande d'énergie interdite à 1,7 eV (soit 0,2 < y < 0,4) .

Pour les applications photovoltaïques, le procédé d'élaboration de couche de pérovskite peut également être utilisée pour fabriquer les cellules solaires simples jonctions à base de pérovskite. Dans ce cas, la pérovskite aura une énergie de bande interdite comprise entre 1,3 eV et 1,5 eV. Il pourra en particulier s'agir de la pérovskite Cs₁₋ₓFAₓPb(I_{1-y}Br_{y})₃ avec x~0,85 et 0,05 < y < 0,25.

Il est également possible de fabriquer une cellule tandem pérovskite (1,2 eV) / pérovskite (1,8 eV) en déposant une première pérovskite en Cs₁₋ₓFAₓPb_{0.5}Sn_{0.5}(I_{1-y}Br_{y})₃ avec x~0,85 et y~0, 05 et une seconde en Cs₁₋ₓFAₓPb(I_{1-y}Br_{y})₃ avec x~0, 85 et y~0,5. L'une des couches de pérovskite ou les deux couches de pérovskite peuvent être formées selon le procédé précédemment décrit.

Divers modes de réalisation et variantes ont été décrits. La personne du métier comprendra que certaines caractéristiques de ces divers modes de réalisation et variantes pourraient être combinées, et d'autres variantes apparaîtront à la personne du métier.

Enfin, la mise en oeuvre pratique des modes de réalisation et variantes décrits est à la portée de la personne du métier à partir des indications fonctionnelles données ci-dessus.

### Exemple illustratif et non limitatif d'un mode de réalisation particulier de l'invention

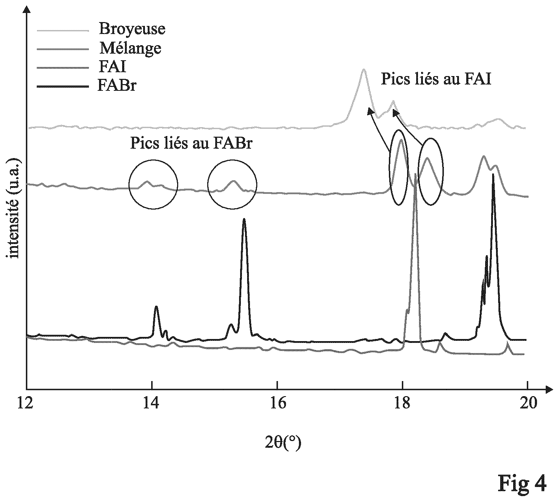

Dans cet exemple, l'étape de mécanosynthèse se fait par co-broyage d'un mélange équimolaire de poudres de FAI et FABr dans une broyeuse planétaire pendant 1h à 500 tours/min (rpm) . Le rapport massique m_{poudre}/m_{billes} est inférieur à 0,2. Une caractérisation par diffraction des rayons X (figure 4) montre que seuls les pics liés au FAI sont visibles. Ils sont largement décalés vers la gauche.

L'absence de pics liés au FABr conjointement avec le décalage des pics de FAI prouve que le Br s'est inséré dans la maille du FAI pour former une solution solide FA(I_{1-y}Br_{y})_{.}

A titre comparatif, la diffraction des rayons X sur un mélange de poudres montre que la signature du FAI et du FABr sont visibles. Ceci confirme que les deux phases (FAI et FABr) coexistent bien dans le mélange de poudres.

Une couche pérovskite hybride organique-inorganique a été déposée par CSS à partir d'une poudre de FA(I_{1-y}Br_{y}) avec 0<y<1 obtenue par mécanosynthèse.

La poudre utilisée peut être sous la forme d'une cible solide de CSS ou encore il est possible de disposer un lit de poudre dans le four de CSS plutôt qu'une cible solide.

Plusieurs couches de pérovskite hybride organique-inorganique de formule Cs₁₋ₓFAₓPb(I_{1-y}Br_{y})₃ ont été fabriquées selon les étapes suivantes :
a) dépôt des précurseurs inorganiques (PbI₂ + CsBr) sur un substrat pour former des couches inorganiques d'environ 250 nm d'épaisseur contenant PbI₂ et CsBr,
b) étape de CSS à partir d'une poudre FA(I_{1-y}Br_{y}) obtenue par mécanosynthèse pour former la pérovskite Cs₁₋ₓFAₓPb(I_{1-y}Br_{y})₃ à partir des précurseurs préalablement déposés.

A tire comparatif, des pérovskites ont également été élaborées à partir d'une cible formée de poudres simplement mélangées.

Les différentes pérovskites obtenues (à partir du mélange de poudres ou à partir de la poudre obtenue par mécanosynthèse) ont été caractérisées par diffraction des rayons des rayons X pour déterminer le taux de Br dans la pérovskite Cs₁₋ₓFAₓPb(I_{1-y}Br_{y})₃. Ce taux peut être déterminé par rapport au décalage du pic (101) à 13,9° de la structure pérovskite.

Elles ont également été caractérisées par spectrométrie UV-Vis pour déterminer la valeur de la bande interdite de la pérovskite (« bandgap »).

Les résultats sont répertoriés dans le tableau suivant :

**[Tableau 1]**

| | [FABr]/([FAI] + [FABr]) dans la cible CSS | T° CSS | Durée CSS | Valeur y | Bande interdite |
|---|---|---|---|---|---|
| mélange de poudres | 12.5 % | 125°C | 40 min | ~ 18% | 1,63 eV |
| mécanosynthèse de poudres | 50 % | 140°C | 10 min | ~ 21% | 1,66 eV |

Le taux de FABr de la cible obtenue par mécanosynthèse a dû être augmenté par rapport à celui de la cible obtenue par simple mélange de poudres. En effet, dans le cas des poudres mélangées, le FABr se sublimant à plus basse température, il réagit préférentiellement pour former la pérovskite. Avec l'étape de mécanosynthèse, la poudre obtenue étant un alliage à l'échelle atomique, la phase gazeuse contient le même taux de Br et I que la cible. Pour obtenir la même quantité de Br dans le gaz, il faut donc augmenter son taux dans la cible. La masse de la cible est inchangée.

Dans le cas de la cible obtenue par mécanosynthèse, la température du procédé a pu être augmentée de 125°C à 140°C et le procédé a été ainsi raccourci de 40 min à 10 min, ce qui est un avantage considérable pour appliquer le procédé à grande échelle.

Les propriétés des couches en termes de qualité cristallographique, taux de Br et énergie de bande interdite sont similaires.

Des couches de pérovskites hybrides organiques-inorganiques ont été déposées sur des substrats en silicium texturé pour fabriquer des cellules tandem sur Si.

Dans le cas d'une couche formée à partir d'une cible obtenue par mélange FAI+FABr, une caractérisation par diffraction des rayons X montre la présence d'une phase pérovskite riche en iode et d'une phase pérovskite riche en brome. Dans le cas d'une couche formée à partir d'une cible composée d'une poudre FAI_{1-y}Br_{y} obtenue par mécanosynthèse, une caractérisation par diffraction des rayons X confirme la présence d'une unique phase pérovskite avec une composition en halogène équivalente à celle de la cible.

## Revendications

1. Procédé d'élaboration d'une couche de pérovskite organique-inorganique comprenant les étapes suivantes :
- Formation d'une couche de précurseurs inorganiques (11) sur un substrat (10),
- Mise en oeuvre d'une étape de sublimation à faible distance à partir d'une poudre (20) de précurseurs organiques, moyennant quoi les vapeurs de la poudre de précurseurs organiques réagissent avec la couche de précurseurs inorganiques (11) et une couche de pérovskite hybride organique-inorganique est formée,
**caractérisé en ce que** la poudre (20) de précurseurs organiques est obtenue par mécanosynthèse en cobroyant au moins un premier groupe de particules en un premier matériau et un deuxième groupe de particules en un deuxième matériau, jusqu'à former un troisième groupe de particules en un troisième matériau, le troisième groupe de particules formant la poudre (20) de précurseurs organiques.

2. Procédé selon la revendication 1, **caractérisé en ce que** la pérovskite hybride organique-inorganique a pour formule A'₁₋ₓAₓBX₃ avec :
A' un cation inorganique ou un alliage de cations inorganiques, choisis parmi Cs, Rb, K et Na,
A un cation organique monovalent ou un alliage de cations organiques monovalents, de préférence choisis parmi le méthylammonium, le formamidinium, le guanidinium, le diméthylammonium et l'imidazolium, encore plus préférentiellement A correspond à MA et/ou FA,
B un cation inorganique ou un alliage de cations inorganiques choisis parmi Pb, Sn et Ge,
X un ou plusieurs halogènes choisis parmi Cl, Br, I et F.

3. Procédé selon l'une des revendications 1 et 2, **caractérisé en ce que** la poudre (20) de précurseurs organiques comprend des particules de formule AX avec A représentant un cation organique monovalent ou un alliage de cations organiques monovalents, de préférence MA et/ou FA, X représentant un ou plusieurs halogènes choisis parmi Cl, Br, I et F et **en ce que** A représente un alliage de cations organiques monovalents et/ou X représente plusieurs halogènes.

4. Procédé selon l'une quelconque des revendications précédentes, **caractérisé en ce que** la pérovskite hybride organique-inorganique a pour formule Cs₁₋ₓMAₓPb(I_{1-y}Br_{y})₃, Cs₁₋ₓFAₓPb(I_{1-y-z}Br_{y}Cl_{z})₃,Cs₁₋ₓFAₓPb(I_{1-y}Br_{y})₃, Cs₁₋ₓFAₓPb_{0.5}Sn_{0.5}(I_{1-y}Br_{y})₃, Cs_{1-x-z}MAₓFA_{z}Pb(I_{1-y}Br_{y})₃ ou Cs_{1-x-z}MAₓFA_{z}Pb₁₋ₖSnₖ(I_{1-y}Br_{y})₃ avec 0 ≤ y ≤ 1, 0 ≤ k ≤ 1, 0 ≤ x ≤ 1, 0 ≤ z ≤ 1 et 0 ≤ x+z ≤ 1.

5. Procédé selon l'une quelconque des revendications précédentes, **caractérisé en ce que** la couche (11) comprenant les précurseurs inorganiques est une couche contenant du Pb, du Cs et un ou plusieurs halogènes choisis parmi l'iode, le brome et le chlore.

6. Procédé selon l'une quelconque des revendications précédentes, **caractérisé en ce que** la poudre (20) de précurseurs organiques est une poudre de FA(I_{1-y}Br_{y}) ou une poudre de MA(I_{1-y}Br_{y}) avec 0 < y < 1.

7. Procédé selon l'une quelconque des revendications précédentes, **caractérisé en ce que** la poudre (20) de précurseurs organiques peut être sous la forme d'une cible solidaire ou d'un lit de poudres.

8. Procédé selon l'une quelconque des revendications 1 à 7, **caractérisé en ce que** la couche de précurseurs inorganiques (11) est formée par évaporation thermique ou dépôt à la tournette.

9. Procédé selon l'une quelconque des revendications 1 à 7, **caractérisé en ce que** la couche de précurseurs inorganiques (11) est formée par sublimation à faible distance.

10. Procédé selon l'une quelconque des revendications précédentes, **caractérisé en ce que** le substrat (10) est un substrat en verre, en plastique, en métal ou en silicium, de préférence un substrat en silicium texturé.

11. Procédé de fabrication d'une cellule photovoltaïque pérovskite à simple jonction ou d'une cellule photovoltaïque multi-jonction comprenant au moins une cellule photovoltaïque en pérovskite, par exemple une cellule photovoltaïque tandem pérovskite-silicium, une cellule photovoltaïque tandem pérovskite-pérovskite, une cellule photovoltaïque triple jonction pérovskite-pérovskite-silicium ou une cellule photovoltaïque triple jonction pérovskite-pérovskite-pérovskite, le procédé comprenant l'élaboration d'une couche de pérovskite organique-inorganique selon le procédé selon l'une quelconque des revendications 1 à 10.
